# EUROPEAN PATENT APPLICATION

(11) **EP 4 075 519 A1**
(43) Date of publication of application: **19.10.2022**
(21) Application number: 21020201.6
(22) Date of filing: 12.04.2021
(51) Int. Cl.: H01L 31/032, H01L 31/055, H01L 31/18, H01L 51/00, H01L 51/05, H01L 31/0352

(54) **ULTRA-THIN PLASMONIC INVERTED PHOTOVOLTAIC PRODUCED AT LOW TEMPERATURE AND METHOD FOR OBTAINING THEREOF**

(71) Applicant: Peafowl Plasmonics AB, 756 51 Uppsala (SE)
(72) Inventor: The designation of the inventor has not yet been filed
(74) Representative: Brann AB

(57) **Abstract**

There is provided a method of obtaining a direct plasmonic photovoltaic cell (1) with inverted architecture that uses low temperature and sustainable chemical formulations comprising the steps of: a) depositing a hole transporting layer (HTL)(3) on a first conductive substrate (2), at a temperature of 100°C or below; b) loading, on the hole transporting layer, metal nanoparticles (41, 42), to form a layer of metal plasmonic nanoparticles; c) depositing on the layer of metal plasmonic nanoparticles an electron transporting layer (ETL) (5) at a temperature of 100°C or below; and d) depositing a second conductive substrate as a back contact (6) on the electron transporting layer (ETL) and a direct plasmonic photovoltaic cell (1) with inverted architecture obtainable by the method mentioned above comprising a first conductive substrate (2); a layer of a p-type semiconductor as a hole transporting layer HTL (3); a layer of metal plasmonic nanoparticles (41, 42) having at least two different shapes; a layer of an n-type semiconductor as an electron transporting layer ETL (5); and a second conductive substrate as a back contact (6).

## Description

The present disclosure relates to a method of obtaining a direct plasmonic photovoltaic cell with inverted architecture using low temperature methods and a direct plasmonic photovoltaic cell with inverted architecture obtainable by said method.

A photovoltaic system is a system using the process of light conversion into electricity. The light may come from the sun or any artificial source. A known example of a photovoltaic cell is a solar cell, wherein solar light is converted into electricity, which has had an increased interest in the last years.

There exist many different kinds of conventional photovoltaics (solar cells), among which silicon cells are the most well-known, but there are also organic solar cells, thin-film solar cells (eg. CIGS, CdTe), perovskite solar cells, etc. Different from the conventional photovoltaics, direct plasmonic solar cells constitute the latest photovoltaic technology, one that differs from all others in the way it absorbs light and creates electrical charges.

In conventional photovoltaic technologies, when a photon is absorbed by the active material, a certain amount of energy is used up to excite an electron from an occupied electronic level to an empty level, and that electron becomes responsible for the current that the cell generates. For a given material, a specific amount of energy is needed to excite ("kick out") an electron, normally labelled as energy gap or bandgap. If the photon has less energy than needed, no electron will be excited by it and if the photon has excess energy, the excess will be wasted as heat. A special type of conventional photovoltaics is the type called *plasmonic-enhanced solar cell.* These are regular solar cells that use plasmonic nanoparticles to scatter light or enhance the active material's light absorption.

By contrast, in direct plasmonic solar cells, the energy conversion happens directly on the plasmonic nanoparticles, which are, in fact, the light absorbers. Direct plasmonic solar cells are built on plasmon electron resonance mechanism. Instead of each photon exciting one specific electron, each photon contributes to the collective excitation of electrons in the material (resonance) that produce the current. A result of this different mechanism is that for a high-energy photon, all of the energy can be converted to electricity - nothing is wasted. There is a limit for how little energy a photon must have for conversion to occur (to produce a cell voltage), but it is much lower than what is typical for other solar cells.

The use of plasmonic electronic resonance for energy conversion enables a much more efficient process since more energy can be converted from the same number of photons. This means that less light needs to be captured to produce the same amount of electricity as a conventional photovoltaic.

In the plasmon electron resonance mechanism, the absorption of light by plasmonic metal nanoparticles heats the loosely bonded valence electrons in the metal nanoparticles, creating an electron hot gas. The dephasing and decoherence of the electron hot gas via the Landau damping mechanism leads to the creation of electrical hot carriers, i.e. hot electrons and holes. Conceptually, plasmonic nanostructures can be used directly in solar cells, but the photo-generated electron-hole pairs are short-lived (a few fs). This makes it problematic to draw current from the device. Thus, to increase charge separation lifetime, the charge carriers can be confined to spatially separated sites where reactions will take place, e.g., by transferring them to a semiconductor (analogous to dye-sensitized solar cells). The hot electrons have sufficient energy to be injected into the conduction band of an electron transporting layer (e.g. TiO₂), which extends significantly their lifetime.

Thus, to make a photovoltaic (solar cell) device, the hot electrons are transferred to an electron transporting layer (ETL) material and the hot holes are transferred to a hole transporting layer (HTL). The electrical charges are subsequently extracted by conductive electrodes.

Plasmonic nanomaterials have another significant advantage when used as light absorbers, namely they absorb at least tenfold more light than any other light absorber, providing versatility in design and placement (outdoor and indoor). This new mechanism enables the development of a novel type of photovoltaic solar cells that are highly transparent and colourless.

Previously, direct plasmonic photovoltaic cells have been developed comprising a layer of silver nanospheres that capture light from 380-450 nm, sandwiched between a TiO₂ (ETL) layer and a HTL layer. The electrical charge is extracted by two conductive electrodes: an FTO glass in contact with the ETL layer and an AZO transparent back contact, on top of the HTL layer. The method of producing includes depositing the TiO₂ layer on the FTO glass by spray pyrolysis at 500°C followed by annealing at 500°C and loading of the Ag nanospheres. Subsequently, an HTL layer is deposited by spin coating using an organic solvent and the back contact is then added by sputtering. In this way, a transparent solar cell with a current power output sufficient to power electrochromic dynamic glass, loT devices and low power displays is achieved.

However, such methods are demanding in terms of energy consumption, scalability, and suitability of chemical agents. In terms of energy consumption, there are two significant energy demanding steps, namely spray pyrolysis deposition and annealing of electron transporting layer (ETL). In terms of unsuitable chemical usage, during the deposition of the HTL layer, the integrity of the Ag nanoparticles needs to be preserved, which limits considerably the solvents that can be used to process the material. Moreover, the deposition of the HTL layer is done be spin coating, which is not scalable. The solvent also limits the range of plasmonic shapes that can be used to nanospheres, which limits light absorption and consequently output power.

Thus, it is desired to increase the direct power generation performance, while ensuring high transparency and colourless nature of the cells so they can be integrated into architectural glazing. Moreover, to comply with UN sustainable goals 7 (affordable and clean energy) and 12 (responsible consumption and production), direct plasmonic solar cells must be produced using low energy manufacturing, sustainable chemical formulations and achieve higher performance.

### <Summary>

It is one aim of the present invention to provide a method of obtaining a direct plasmonic photovoltaic cell with inverted architecture that is easy to be reproduced, uses low energy (no high temperature) and sustainable chemical formulations. Further, the method may be used to obtain direct plasmonic photovoltaic cells with inverted architecture that produce more power than other known direct plasmonic photovoltaic cells and can have a high transparency and are colourless at the same time.

According to a first aspect, the invention relates to a method of obtaining a direct plasmonic photovoltaic cell with inverted architecture, comprising the steps of:
a) depositing a hole transporting layer (HTL) on a first conductive substrate, at a temperature of 100°C or below;
b) loading, on the hole transporting layer, metal nanoparticles, to form a layer of metal plasmonic nanoparticles;
c) depositing on the layer of metal plasmonic nanoparticles an electron transporting layer (ETL) at a temperature of 100°C or below; and
d) depositing a second conductive substrate as a back contact on the electron transporting layer (ETL).

According to a second aspect, the invention relates to a direct plasmonic photovoltaic cell with inverted architecture that can be manufactured using the method described above, comprising:
- a first conductive substrate;
- a layer of a p-type semiconductor as a hole transporting layer (HTL);
- a layer of metal plasmonic nanoparticles having at least two different shapes;
- a layer of an n-type semiconductor as an electron transporting layer (ETL); and
- a second conductive substrate as a back contact.

### <Definitions>

The term "transparent" is used here in its broadest sense, meaning the quality an object or substance has when you can see through it, or when it does not significantly influence the perception of the underlying material. Different degrees of transparency are required depending on the intended use of the solar cells disclosed herein. For example, a high degree of transparency is desired when the solar cells are incorporated on window glass, and a lower degree of transparency when incorporated on other building materials.

The term "colourless" as used here, in relation to a layer, system or device, refers to a colour-neutral layer or device that does not have a distinguishable colour, as measured using the CIE 1931 RGB colour space developed by the International Commission on Illumination (CIE) in 1931.

### <First conductive substrate>

The first conductive substrate is, for example, of a transparent glass material with a conductive layer on one of the sides or of a conductive polymer. Preferred examples of transparent glass material are fluorinated tin oxide (FTO), indium tin oxide (ITO), aluminium doped zinc oxide (AZO) or indium doped zinc oxide (IZO). Similarly, preferred examples of a conductive polymer substrate may be either a polymer substrate with a conductive layer on one side or a substrate made of a conductive polymeric material intrinsically conducting polymer or, for example, a substrate made of a conductive thermoplastic composite material.

### <Hole transporting layer (HTL)>

The term "p-type semiconductors" which is used herein having the same meaning with "hole transporting layer (HTL)" refers to semiconductor materials in which holes are the majority carriers, or positively charged carriers, and electrons are the minority carriers.

Examples of suitable HTL materials include CuSCN, AgSCN, Cul, PEDOT.PSS (poly(3,4-ethylenedioxythiophene) polystyrene sulfonate), Spiro:OMeTAD (2,2',7,7'-Tetrakis[N,N-di(4-methoxyphenyl)amino]-9,9'-spirobifluorene), PTAA (Poly[bis(4-phenyl)(2,4,6-trimethylphenyl)amine), CuXO₂ (wherein X is for example Cr, B, Al, Ga, In, Sc, Fe),and combinations thereof. Preferably, the HTL materials is CuSCN.

According to a preferred embodiment, the HTL layer has an average thickness of about 500 nm or less, preferably 250 nm or less, more preferably 150 nm or less, e.g. 120 nm,100 nm, 50 nm or less. More preferably, the HTL layer is transparent. Even more preferably, the HTL layer is transparent and colourless.

The thickness of the HTL layer may be determined by SEM.

### <Deposition of the hole transporting layer (HTL)>

In the known methods of manufacturing direct plasmonic photovoltaic cells, the HTL is deposited on top of the metal nanoparticles, which were previously loaded on the ETL. The deposition of the HTL on top of the metal nanoparticles is subject to limitations due to the fragility of the nanoparticles. In order to preserve the integrity of the metal nanoparticles, the solution pH must be kept around neutral, which limits the use of water based formulations and solvents that can be used to process the material.

In addition, only sphere shapes may be employed for the nanoparticles, as they are more robust and resistant to further processing in the presence of a solvent. This limits the absorption capacity of the cell, as will be explained later.

According to the present invention, the HTL layer is deposited before the plasmonic material, which allows that other solvents including water may be used. The use of water-based solvents enables for a more sustainable, processable and scalable manufacturing methods like printing or spraying. Having the HTL layer deposited first rather than the ETL layer brings advantages to the process both in terms of reducing energy and use of sustainable chemical formulations. This is because there is a restricted list of suitable materials for the HTL and solvents that can be deposited on top of the plasmonic nanoparticles without affecting their integrity. In contrast, it is relatively easy to find materials for the ETL that can be processed at low temperatures and deposited on top of plasmonic nanoparticles using sustainable solvents (e.g. water-based) at an adequate pH. If deposited first, i.e. before the metal nanoparticles, transparent HTL layers can be made from water-based solutions and annealed at temperatures below 100°C without generating pinholes.

Pinhole free first layer is essential to obtain a good performing solar cell device. Pinholes affect negatively the three performance parameters (short circuit photocurrent, open circuit voltage and fill factor) of a solar cell. Pinholes can originate from conductive substrate unevenness and ununiform coverage, which is typically counteracted by depositing thick layers that decrease the overall transparency. Additionally, to ensure a good first layer conductivity, thick layers must be annealed at high temperature (> 300°C), making them prone to cracks and pinhole formation. According to the present method, thin and pinhole free hole transport layers HTL may be obtained at low temperature, increasing the overall solar cell transparency and reducing energy consumption.

Possible methods of deposition of the HTL layer onto of the first conductive substrate include but are not limited to electrodeposition, spray-coating, inkjet printing, slot-die printing, screen-printing, drop-casting, spin-coating, dip-coating, atomic layer deposition, sputtering or any other way that allows the formation of continuous HTL layer at low temperatures of 100°C or below. Still according to a preferred embodiment, the HTL layer was deposited by electrodeposition.

### <Metal nanoparticles>

Any metal nanoparticle may be used in the layer of metal nanoparticles having any geometrical shape, as long as it provides optical absorption in the optical range defined as electromagnetic spectrum ranging from UV to near Infrared (300-1200 nm), measured by UV-Vis optical absorption and reflectance.

Furthermore, preferably the particles have less than 200 nm in size irrespective of their geometrical shape, in order to further decrease light scattering and reflection. Particle size according to the present invention is assessed by Dynamic Light Scattering (DLS).

In a preferred embodiment, the metal nanoparticles have at least two different geometrical shapes selected from sphere, cube, triangular prism, pyramid, urchins, or others. More preferably, the metal nanoparticles have sphere and prism geometrical shapes. When different geometrical shapes of metal nanoparticles are present, the absorption of light is significantly increased. This is because optical absorption of the nanoparticles changes with the shapes and sizes thereof. If silver nanospheres may absorb light in a range from 380 to 450nm, by adding other shapes like triangular prism nanoparticles, the optical absorption may be enlarged to encompass electromagnetic spectrum of up to 1200nm.

The light absorption may also change with the size of the nanoparticles. For example, silver nanoparticles with a triangular prism shape having a thickness of 5-10 nm and wherein the sides of the triangular base have a length of about 20nm may absorb light in a range from 400 to 600nm, with a length of about 30nm may absorb light in a range from 500 to 650nm, or with a length of about 50nm may absorb light in a range from 550 to 800nm.

While the optical absorption may be enlarged by modifying only the size of a particle and keeping the same geometrical shape, it is to be considered that when increasing too much the dimension of a nanoparticle, the plasmonic effect is reduced and the reflectivity is increased, which leads to a drop in the effectiveness of the cell. On the contrary, when different geometrical shapes having similar sizes are used, the optical absorption is enlarged while the plasmonic effect is maintained in optical limits.

The proportion between the spheres and the prisms nanoparticles can be selected based on the desired source light spectrum and required level of transparency. For example, in order to cover absorption of light from most of the solar spectrum, approximatively equal amounts of nanospheres and triangular prism with different sizes may be used in a proportion of 1:1:1:1.

The metal nanoparticles are preferably chosen from copper, gold, silver or aluminium nanoparticles. More preferred, the metal nanoparticles are silver nanoparticles.

The layer of nanoparticles is formed as a sub-monolayer wherein the nanoparticles are situated sparsely from each other, preferably at a distance of at least 3 nm from each other, in order to have low interference in the plasmonic effect of each individual nanoparticle.

Preferably, the concentration of nanoparticles in a sub-monolayer is between 10-20% of a compact monolayer, to obtain a photovoltaic system which is colourless or with high transparency.

In one embodiment, the layer of nanoparticles has a thickness in the range of about 15 to about 250 nm, as measurable by SEM.

According to a preferred embodiment, freely combinable with any of the above embodiments, the metal nanoparticles are synthesized by using a reducing and a stabilizing agent. Examples of reducing agents include NaBH₄, N₂H₄, ascorbic acid, betanin, polyols for example ethylene glycol, di-ethylene glycol, triethylene glycol, tetraethylene glycol, polyethylene glycol. Examples of stabilizing or growth-limiting agents include betanin, polyvinylpyrrolidone, polyvinyl acetate, polyols such as for example ethylene glycol, diethylene glycol, triethylene glycol, tetraethylene glycol polyethylene glycol or ascorbic acid. In a preferred embodiment, ascorbic acid is used as the stabilizing agent

### <Loading of metal NPs>

In step b), the metal nanoparticles may be loaded onto the HTL layer by inkjet printing, screen-printing, drop-casting, spin-coating, dip-coating, spray-coating, or any other way that allows the formation of a sub-monolayer on the insulating layer. More preferred, spray coating is used.

All the above presented methods are well known to the skilled person in the art and can be performed without undue burden.

In the known methods of obtaining direct plasmonic photovoltaic cells, the metal nanoparticles are loaded on an electron transport layer (ETL), followed by the deposition of the HTL layer. When depositing the HTL layer, solvents are used that may affect the integrity of the metal nanoparticles. For this reason, only nanoparticles with spherical shape could be used, that are more robust and resistant.

According to the present invention, the deposition of the HTL layer is made before loading the nanoparticles, which allows that other shapes are loaded, as well, to increase the absorption of light. The subsequent deposition of the ETL layer does not affect the integrity of these shapes, since the materials used are in water solvents and their formulations are in pH range (pH between 3-8) compatible with the metal nanoparticles (e.g. silver nanoparticles) of different shapes and sizes.

### <Electron transporting layer (ETL)>

The term "n-type semiconductors" which is used with the same meaning as "electron transporting layer (ETL)" refers to semiconductor materials in which electrons are the majority carriers and holes are the minority carriers.

Examples of suitable ETL materials include SnO₂, ZnO, TiO₂, doped ZnO (eg AI:ZnO, In:ZnO), SrTiO₃, BrTiO₃, Sb₂O₅, doped Sb₂O₅ (eg. Sn-Sb₂O₅) and combinations thereof. Preferably, the ETL materials are SnO₂ and ZnO.

According to a preferred embodiment, the ETL layer has a thickness of about 200 nm or less, preferably 150 nm or less, more preferably 120 nm or less, e.g. 100 nm, 80 nm, 50 nm or less. More preferably, the ETL layer is transparent. Even more preferably, the ETL layer is transparent and colourless.

The thickness of the ETL layer is represented by the average thickness as determined for example by Scanning Electron Microscopy (SEM).

### <Deposition of the electron transporting layer (ETL)>

In step c), The ETL is deposited via spray-coating or inkjet printing at low temperature of below 100°C.

Other possible methods of deposition of the ETL layer onto of the metal nanoparticles layer include but are not limited to screen-printing, slot-die printing, drop-casting, spin-coating, dip-coating, atomic layer deposition, sputtering or any other way that allows the formation of a continuous ETL layer at low temperatures of 100°C or below.

### <Second conductive substrate (back contact)>

The back contact is made, for example, of a sputtered conductive oxide like indium tin oxide (ITO), aluminium doped zinc oxide (AZO) or indium doped zinc oxide (IZO). Additionally, it may be made of a transparent glass material with a conductive layer on one of the sides or of a conductive polymer. Preferred examples of transparent conductive glass material are fluorinated tin oxide (FTO), indium tin oxide (ITO), aluminium-doped zinc oxide (AZO) or indium doped zinc oxide (IZO). Similarly, preferred examples of a conductive polymer substrate may be either a polymer substrate with a conductive layer on one side or a substrate made of a conductive polymeric material intrinsically conducting polymer or, for example, a substrate made of a conductive thermoplastic composite material.

In a preferred embodiment, the back contact may comprise a mixture of Ag nanowires and conductive oxides (e.g. SnO₂, AZO) or conductive polymer (e.g. PEDOT:PSS), or a mixture of graphene and conductive polymer which can be integrated in a transparent and colourless solar cell.

### <Deposition of the second conductive substrate>

The second conductive substrate is deposited on top of the ETL in step e).

The deposition may be made in any suitable way, for example by sputtering or using a second conductive substrate, such as conductive glass or plastic.

In a preferred embodiment, when a mixture of Ag nanowires and conductive oxides or conductive polymers are used as the back contact, the deposition may be made by slot-die coating. This avoids using the commonly used sputtering technique, which has high energetic costs (requires high vacuum) and requires sophisticated machinery. Also, the damaging nature of the sputtering plasma may result in a significant amount of shunt cells per batch, which would be avoided in this case.

### <Further layers>

Further layers or compounds (e.g. molecular linkers) may be present between the layers depicted above.

If other layers are present, the deposition thereof will be made by any method depicted above, as long as the method employed does not affect the integrity of the metal nanoparticles or of the other layers.

For example, according to another embodiment, the p-type semiconductor (HTL), the metal nanoparticles and/or the n-type semiconductor (ETL) are covalently linked by means of a molecular linker. The requirements for the molecular linker are that it should provide an excellent electronic coupling because of its good π-conjugated properties, rigidity and planarity. Preferably, molecules with selective reactive groups to each component, namely carboxylic or phosphonic acid (coordination to p-type semiconductor) and amine or thiols (coordination to the nanoparticles) are used. Examples of suitable molecular linkers are as disclosed in the international application WO2018/178153 A1, and are incorporated herein by reference.

Still according to another preferred embodiment, an insulating layer is situated between the ETL and the layer of metal nanoparticles. The insulating layer is composed of materials with a large energy difference between valence and conduction band, i.e., large band gap, and no or very low electrical conductivity. The conduction band edge should be at 3.5 eV or less from the vacuum and the valence band should be 6.5 eV or more from the vacuum. As an example, the insulating layer can be made of SiO₂, Al₂O₃, ZrO₂, tetraethyl orthosilicate (TEOS), (3-aminopropyl)triethoxysilane (APTES), (3-mercaptopropyl) triethoxysilane, aminophenyltrimetoxysilane, organophosphates (CₙH₂ₙ₊₁-PO(OH)₂), amino-organophosphates (H₂N-CₙH₂ₙ-PO(OH)₂), thiol-organophosphates (HS-C₂H₂ₙ-PO(OH)₂), organocarboxilates (CₙH₂ₙ₊₁-CO(OH)), amino-organocarboxilates (H₂N-CₙH₂ₙ₊₁-CO(OH)) and thiol-organocarboxilates (HS-CₙH₂ₙ₊₁-CO(OH)). Preferably, the insulating layer has a thickness of 10 nm or less, more preferably 1 nm or less, even more preferably 1nm or less. When the thickness of the insulating layer is 10nm or less, it is ensured that hot electrons are effectively transferred from the metal nanoparticles layer to the ETL. If the thickness of the insulating layer is less than 0.5 nm, then the insulating effect may not be achieved.

### <Use of the solar cell>

In a further aspect, the invention relates to a transparent foil for electrically charging a consumer electronic device or for a building element. The consumer electronic device may relate to any equipment intended for everyday use and that preferably requires a low electricity consumption, such as e-paper displays, internet of things devices (e.g. sensors), smart devices, smart watches, mobile phones, tablets, etc. The building element may relate to a window, a roof element, a wall element, or other structural or functional element.

### <Figures>

Different aspects and embodiments of the invention will be described in closer detail below, in the description and examples, with reference to the drawings in which:
Fig. 1 schematically shows a conceptual design of a direct plasmonic solar cell, according to a preferred embodiment of the present invention
Fig. 2 represents a graph showing the changes of optical absorption with changes in plasmonic shape and size

### <Examples>

### Example 1 Materials used

Silver metal nanoparticles were synthesized starting from the respective metal precursor, for example AgNO₃, a reducing agent, and a stabilizing agent. Examples of reducing agents and stabilizing agents were mentioned earlier in the present invention. All reagents were purchased from Sigma-Aldrich / Merck and were of analytical quality.

The present inventors followed the protocol presented in Dong, H., Chen, Y.-C., Feldmann, C. "Polyol synthesis of nanoparticles: status and options regarding metals, oxides, chalcogenides, and non-metal elements", Green. Chem. 17, 4107-4132 (2015) to make nanospheres and Aherne, D., Ledwith, D. M., Gara, M. & Kelly, J. M. "Optical properties and growth aspects of silver nanoprisms produced by a highly reproducible and rapid synthesis at room temperature", Adv. Funct. Mater. 18, 2005-2016 (2008) for triangular nanoprisms, incorporated herein by reference, changing selected parameters such as the concentration of components, solvents, reaction temperature, and reaction time in order to optimize the geometry of the nanoparticles and the size distribution.

If a linker is used, the pH of the Ag nanoparticle suspension is adjusted to 4 - 5 and the particles are coated with pABA (Sigma-Aldrich), which anchors to Ag surface via the -NH₂.

In the same way, gold, copper and aluminium nanoparticles may be obtained starting from the respective metal precursor, as it is obvious for a person skilled in the art, for example CuSO₄ or CuCl₂ for copper nanoparticles or HAuCl₄ for gold nanoparticles.

As an HTL, CuSCN was used having a thickness of 100 nm obtained via electrodeposition of 12 mM of CuSO4 and 12 mM KSCN.

As an ETL, SnO₂ was used having a thickness of 30 nm obtained from SnO₂ colloidal solution (15% in H₂O colloidal dispersion).

Alternatively, as an ETL, ZnO was used having a thickness of 30 nm obtained from inkjet dispersion from Sigma-Aldrich.

As a first conductive layer, FTO (fluorinated tin oxide) glass was used with a thickness of 2 mm obtained from NSG-Pilkington.

As a second conductive layer, slot-die coated silver nanowires with a conductive oxide (SnO2, AZO) or polymer (PEDOT:PSS) was used.

Alternatively, as a second conductive layer, a sputtered AZO layer with 150-200 nm thickness may be used.

### Example 2 Direct plasmonic solar cell with inverted architecture

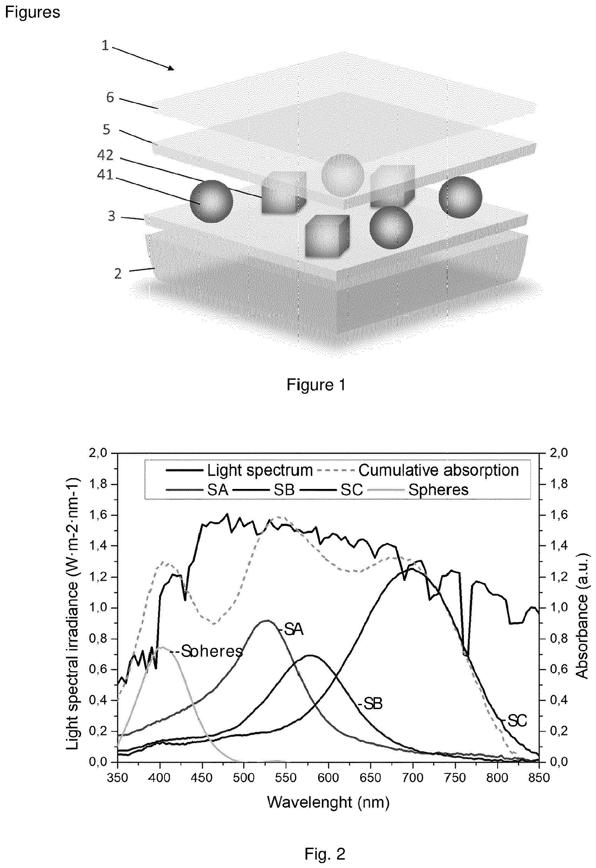

Figure 1 shows a direct solar cell with inverted architecture 1 according to the present invention. A CuSCN hole transporting layer 3 is deposited on top of a first conductive substrate 2 made of FTO glass. Silver nanoparticles having spherical shape 41 and cubic shape 42 are situated on top of the HTL layer 3 and below the electron transport layer ETL 5 made of SnO₂ or ZnO. The silver nanoparticles may have different sizes and/or other geometrical shapes (not shown), for example triagonal prisms. On top of the ETL 5 is placed a back contact 6 made of a mixture of Ag nanowires and conductive oxides (e.g. SnO₂ or AZO).

The described architecture allows for a more efficient absorption of light due to the different geometrical shapes of metal nanoparticles that absorb light at different wavelengths, as shown in Figure 2. As can be seen, spherical silver nanoparticles that maintain a plasmonic effect absorb light in a range from 380-450nm. Silver nanoparticles with a triangular prism shape having a thickness of 5-10 nm absorb light in a range from 400 to 600nm, wherein the sides of the triangular base have a length of about 20nm (SA), in a range from 500 to 650nm, wherein the sides have a length of about 30nm (SB) or in a range from 550 to 800nm, wherein the sides have a length of about 50nm (SC). By varying the shapes and sizes of the metal nanoparticles it can thus be obtained a cumulative absorption (represented with a dotted line) that matches as much as possible the light spectrum.

Example 4 Exemplary method of obtaining a direct plasmonic photovoltaic cell with inverted architecture
a) A solar cell according to this embodiment was obtained in the following way: an FTO glass was cut into sizes of 14 mm x 24 mm. These dimensions are chosen to give some tolerance of the glass pieces for the final deposition steps and measurement. After cutting, the glass was patterned by chemical etching. The long sides of each pre-cut substrate are taped (use 3M-Magic tape or Kapton) so that they cover around 2 mm on each end. The FTO is then covered with zinc powder (only a pinch required). This is followed by adding drops of 2M HCI onto the FTO glass to start the etching reaction. After approximatively 2 min the etching is complete and the etching solution is washed off with water. The glass pieces are further washed by sonication in 2% Hellmanex solution (diluted with DI water) for 30 min. Afterwards, washing by sonication in DI water for 15 minutes, followed by 15 minutes of IPA is performed. The cleaning procedure is finished with a 15 min UV-Ozone treatment process.
b) The precursor solution for the copper thiocyanate (CuSCN) electrodeposition consists of an aqueous solution of 12 mM copper sulphate (CuSO₄), 12 mM ethylene diaminetetra acetic acid (EDTA) and 12 mM potassium thiocyanate (KSCN). The FTO is immersed in this solution acting as a working electrode, a platinum wire acts as a counter electrode and a silver/ silver chloride (Ag/AgCI) electrode as reference. The films are formed applying -0.455 V for 20s three times, leaving 30s of waiting in between each time. When the deposition is finished, the glass is rinsed with distilled water and dried with N₂ gas. To remove pinholes a thin CuSCN layer (ca. 10 nm) was spin-coated (3000 rpm for 30 sec) on top of the electrodeposited layer using a CuSCN in 50% aqueous ammonia solution at a concentration 10 mg/mL.
c) The layer of metal nanoparticles is then loaded on the HTL layer (CuSCN). In the present embodiment, silver spheres and triangular prisms were used. Silver nanospheres were synthesized from 0.8 ml Glycerol, 8.2 H₂O, 0.1 ml AgNO₃, and 0.5 ml Na-citrate, which were mixed in a microwave tube. After 30 min at 95°C, a solution of Ag NPs was obtained and then purified in centrifuge at 14.8 K rpm for 20 min. The NPs were then re-dispersed in 2 ml H₂O. Silver triangular nanoprisms were synthesized using a two-step method. The first step related to the synthesis of a seed solution and the second one the seeds were grown into nanoprisms. The seed solution was produced mixing aqueous trisodium citrate (5 mL, 2.5 mM), aqueous poly(sodium styrenesulphonate) (PSSS) (0.25 mL, 500 mg/L), aqueous sodium borohydride (0.3 mL, 10 mM, freshly prepared) and aqueous silver nitrate (5 mL, 0.5 mM, 2 mL/min) under vigorous stirring. The yellowish obtained solution was ready for use and could be stored in the refrigerator for further steps. To grow the nanoprisms, water (5 mL), aqueous ascorbic acid (75 µL, 10 mM), seed solution (various quantities to obtain different prism sizes, we used from 0.1-1 mL from the seeds stock solution) and aqueous silver nitrate (3 mL, 0.5 mM, 1 mL/min) were mixed under vigorous stirring. Once the addition of AgNO₃ had been finished, aqueous trisodium citrate (0.5 mL, 25 mM) was immediately added to the mixture and stirred for around a minute. Samples were kept as prepared in the refrigerator for a minimum of 48 h before using them. The silver plasmonic nanoparticles were deposited on the HTL layer (CuSCN) as follows: pre-made silver spheres and prisms were mixed and spray deposited at room temperature on top of the CuSCN layer. A minimum of two silver nanoparticles shapes were used. Using DI-H2O, the FTO/CuSCN/Ag NPs films were washed thoroughly and dried using Ar gas.
d) SnO₂ was used as electron transporting material (ETL). The tin oxide layer was deposited by spin coating. The solution consisted of tin(IV) oxide nanoparticles, 15% in H₂O colloidal dispersion; diluted 1:4 in water. The spin coating parameters were 3000 rpm for 30s. After deposition, the layer was annealed at 100°C for 45 minutes. To remove pinholes on the deposited SnO₂ layer a thin SnCl₂ layer (ca. 10 nm) was spin-coated (3000 rpm for 30 sec) using a SnCl₂ solution at a concentration 1 mg/mL. After deposition, the layer was annealed at 100°C for 15 minutes to convert the SnCl₂ into SnO₂.
e) Finally, silver nanowires (Ag NWs) from Sigma-Aldrich were deposited onto the ETL layer as a back contact for the solar cell via slot die coating. 1.2 wt% of Ag NWs (diameter × length = 50 nm (±10 nm) × 40 µm (±5 µm), 5 mg/mL in isopropyl alcohol) were dispersed in a solution of ethylene glycol (2 vol %) in isopropyl alcohol (98 vol%). 0.005g/mL of D520 Nafion dispersion-alcohol based 1000 EW from Dupont were added as dispersant, to avoid Ag NWs aggregation. The gap between the slot-die coater and the solar cell was set at 0.05 mm and a shim plate was used with a thickness of 0.03 mm and a printing speed of 50 RPM. After depositing of Ag NWs, the sample was sprayed with a 6wt% solution of SnCl₄.5H₂O. The cell was then dried and annealed at 80°C for 15 minutes to increase connectivity between Ag NWs and fill the gaps between wires.

By following this procedure, a solar cell as presented in Figure 1 was obtained, comprising silver nanoparticles with spherical and triagonal prism (not shown) shapes.

## Claims

1. Method of obtaining a direct plasmonic photovoltaic cell (1) with inverted architecture, comprising the steps of:
a) depositing a hole transporting layer (HTL)(3) on a first conductive substrate (2), at a temperature of 100°C or below;
b) loading, on the hole transporting layer, metal nanoparticles (41, 42), to form a layer of metal plasmonic nanoparticles;
c) depositing on the layer of metal plasmonic nanoparticles an electron transporting layer (ETL) (5) at a temperature of 100°C or below; and
d) depositing a second conductive substrate as a back contact (6) on the electron transporting layer (ETL).

2. Method according to claim 1, wherein the photovoltaic cell is transparent.

3. Method according to claim 1 or 2, wherein the hole transporting layer is CuSCN or AgSCN,

4. Method according to any preceding claim wherein the hole transporting layer is deposited by electrodeposition.

5. Method according to any preceding claim wherein the metal nanoparticles are selected from the group consisting of copper, gold, silver or aluminium.

6. Method according to any preceding claim wherein the layer of metal plasmonic nanoparticles is a sub-monolayer.

7. Method according to any preceding claim wherein the metal nanoparticles have at least two different shapes selected from triangular prism, pyramid or urchins.

8. Method according to any preceding claim wherein the metal nanoparticles are loaded by spray-coating.

9. Method according to any preceding claim wherein the electron transporting layer is made of SnO₂ or ZnO.

10. Method according to any preceding claim wherein the electron transporting layer is deposited by via spray-coating, spin-coating or inkjet printing.

11. Method according to any preceding claim wherein the back contact is made of a mixture of Ag nanowires and a conductive oxide like SnO₂ or aluminium doped zinc oxide (AZO), a mixture of Ag nanowires and a conductive polymer or a mixture of graphene and conductive polymers.

12. Method according to any preceding claim wherein the back contact is transparent and is deposited by slot-die coating.

13. Direct plasmonic photovoltaic cell (1) with inverted architecture comprising:
- a first conductive substrate (2);
- a layer of a p-type semiconductor as a hole transporting layer HTL (3);
- a layer of metal plasmonic nanoparticles (41, 42) having at least two different shapes;
- a layer of an n-type semiconductor as an electron transporting layer ETL (5); and
- a second conductive substrate as a back contact (6).

14. Direct plasmonic photovoltaic cell with inverted architecture according to claim 13 obtained by a method according to any of claims 1-12.

15. Transparent foil for electrically charging a consumer electronic device made of the direct plasmonic photovoltaic cell according to claims 12 or 13.
